# EUROPÄISCHE PATENTANMELDUNG

(11) **EP 1 437 600 A1**
(43) Veröffentlichungstag der Anmeldung: **14.07.2004**
(21) Anmeldenummer: 03029656.0
(22) Anmeldetag: 23.12.2003
(51) Int. Cl.: G01R 31/36

(54) **Schaltung und Verfahren zur Erfassung von Erdschlussfehlern**

(30) Priorität: 09.01.2003 DE 10300539
(71) Anmelder: DaimlerChrysler AG, 70567 Stuttgart (DE)
(72) Erfinder: Herb, Ulrich, 87637 Görisried (DE); Hornung, Hans-Georg, 86875 Waal (DE)

(57) **Zusammenfassung**

Eine Schaltung (1) zur Überwachung des Widerstandes zwischen den Klemmen einer Batterie (2) und einem ersten Referenzpotential (GND) umfasst zwei jeweils mit einer der Klemmen der Batterie (2) zu verbindende Eingängen (3,4) und einen Spannungsteiler (Rm1,Rm2), der zwei jeweils mit einem der Eingänge (3,4) verbundene Außenanschlüsse (6,7) und einen mit dem ersten Referenzpotential (GND) zu verbindenden Mittelanschluss (5) aufweist, zwei jeweils in einer Verbindung zwischen einem der Außenanschlüsse (6,7) des Spannungsteilers (Rm1,Rm2) und einem der Eingänge (3,4) in Reihe angeordnete Schalter (S1,S2) und ein mit den Außenanschlüssen (6,7) des Spannungsteilers verbundenes Messinstrument (8) zum Liefern eines für die Spannung zwischen den Außenanschlüssen (6,7) repräsentativen Überwachungssignals (Uiso).

## Beschreibung

Die vorliegende Erfindung betrifft eine Schaltung zur Überwachung des Widerstandes zwischen den Klemmen einer Gleichspannungsquelle wie etwa einer Batterie und einem ersten Referenzpotential sowie ein Verfahren, das eine solche Schaltung einsetzt.

Aus dem Buch "Schutztechnik und Isolationsüberwachung", Wolfgang Hofheinz, 6. Auflage, VDE, Kapitel 14.3.1 ist eine Schaltung zur Überwachung des Widerstandes bzw. zur Erfassung von Isolationsfehlern zwischen den Klemmen einer Gleichspannungsquelle und einem Massepotential beschrieben. Diese Schaltung verwendet jeweils zwei jeweils zwischen eine Klemme der Gleichspannungsquelle und das Massepotential geschaltete Messinstrumente mit einem Innenwiderstand Rᵢ, um einen Isolationsfehler zwischen dem Massepotential und der jeweils anderen Klemme der Gleichspannungsquelle anhand eines Spannungsabfalls an dem Innenwiderstand Rᵢ zu erfassen, der aus einem Stromfluss von der einen Klemme zur Masse über das Messinstrument und von der Masse zur anderen Klemme über den Isolationsfehler resultiert. Ein drittes Messinstrument dient zur Erfassung der Potentialdifferenz zwischen den zwei Klemmen der Gleichspannungsquelle.

Die große Zahl von Messinstrumenten macht die bekannte Schaltung aufwändig und kostspielig.

Ziel der Erfindung ist, eine besonders einfache und preiswerte Schaltung zur Überwachung des Widerstandes zwischen den Klemmen einer Gleichspannungsquelle anzugeben.

Durch die Erfindung, wie in Anspruch 1 definiert, gelingt es, die Zahl der benötigten Messinstrumente auf ein einziges zu reduzieren. Indem die Eingänge dieses einzigen Messinstruments jeweils mit den Außenanschlüssen eines Spannungsteilers verbunden sind, dessen Mittelanschluss auf dem ersten Referenzpotential gehalten ist, genügen als Schalter zum Umschalten zwischen einer Messung zwischen der ersten Klemme und dem Referenzpotential, der zweiten Klemme und dem Referenzpotential bzw. beiden Klemmen einfache Unterbrecher.

Die zwischen den Außenanschlüssen und dem Mittelanschluss des Spannungsteilers in Reihe geschalteten Widerstände sind vorzugsweise identisch.

Um eine Messung auch bei hohen Ausgangsspannungen der Batterie zu ermöglichen, ist vorzugsweise in jeder Verbindung zwischen einem der Außenanschlüsse des Spannungsteilers und einem der Eingänge der Schaltung ein Vorwiderstand in Reihe geschaltet, wobei wiederum auch die Vorwiderstände vorzugsweise identisch sind.

Für automatisierte Widerstandsüberwachung ist vorzugsweise eine Steuereinheit vorgesehen, die unter anderem dazu dient, den ersten und den zweiten Schalter gegenphasig zu öffnen bzw. zu schließen.

Die Widerstände des Spannungsteilers und die Vorwiderstände sind vorzugsweise Ohmsche Widerstände, unter Umständen kommen jedoch auch Widerstände mit imaginärer Komponente des Widerstandswertes in Betracht.

Als Messinstrument kann ein preiswerter Differenzverstärker eingesetzt werden.

Wenn dieser Differenzverstärker mit einem zweiten Referenzpotential als Versorgungspotential beschaltet ist, das unter Umständen von dem ersten Referenzpotential abweichen kann, so ist vorzugsweise eine Prüfspannungsquelle vorgesehen, von deren zwei Klemmen die eine mit einem das zweite Referenzpotential führenden Punkt der Schaltung verbunden ist, und die zweite über einen dritten Schalter mit einem der Außenanschlüsse des Spannungsteilers verbunden ist. Indem dieser dritte Schalter geschlossen und so das Potential der zweiten Klemme der Prüfspannungsquelle an das Messinstrument angelegt wird, kann festgestellt werden, ob die am Messinstrument anliegende Spannung von einer bekannten Ausgangsspannung der Prüfspannungsquelle signifikant abweicht, was auf eine Potentialdifferenz zwischen dem ersten und dem zweiten Referenzpotential schließen lässt.

Eine solche Potentialdifferenz kann insbesondere dann auftreten, wenn die Schalter, die Widerstände und das Messinstrument in einer Baueinheit zusammengefasst sind, der Mittelanschluss des Spannungsteilers durch einen ersten Leiter an das außerhalb der Baueinheit definierte erste Referenzpotential angeschlossen ist und auf einem zweiten Leiter, der den oben erwähnten Punkt mit dem ersten Referenzpotential außerhalb der Baueinheit verbindet und so das zweite Referenzpotential definiert, ein Spannungsabfall auftreten kann.

Vorzugsweise wird die erfindungsgemäße Schaltung eingesetzt zur Erfassung von Isolationsfehlern an einer in ein Fahrzeug, insbesondere ein elektrisch angetriebenes Fahrzeug, eingebauten Batterie. In diesem Fall ist das erste Referenzpotential vorzugsweise die Fahrzeugmasse.

Zur Erfassung des Widerstandes zwischen den Batterieklemmen und dem ersten Referenzpotential wird vorzugsweise abwechselnd der erste Schalter geschlossen und der zweite geöffnet, um eine erste, dann an der Messschaltung anliegende Spannung zu erfassen, und dann der erste Schalter geöffnet und der zweite Schalter geschlossen, um eine zweite anliegende Spannung zu erfassen, und ein Isolationsfehler wird dann angezeigt, wenn wenigstens eine der erfassten Spannungen einen Grenzwert überschreitet.

Um vor einer solchen Messung Funktionsstörungen der Schaltung auszuschließen, werden zweckmäßigerweise diverse Prüfschritte durchgeführt.

Ein erster solcher Prüfschritt umfasst das Öffnen aller Schalter, das Erfassen der dann an der Messschaltung anliegenden Spannung, die - abgesehen von einem Offset des Messinstruments - zu dieser Zeit Null sein sollte, und das Erkennen eines Fehlers der Schaltung, wenn die Spannung einen Grenzwert überschreitet, indem sie zum Beispiel negativ oder größer als 0,1 V wird.

Ein weiterer Prüfschritt umfasst das Öffnen des ersten und des zweiten Schalters und das Schließen des dritten Schalters, um die bereits erwähnten eventuellen Abweichungen zwischen dem ersten und dem zweiten Referenzpotential zu erfassen, und das Erkennen eines Fehlers der Schaltung, wenn die Spannung einen Grenzwert überschreitet, zum Beispiel wenn sie jenseits von 0 ± 0,8 V liegt.

Durch Schließen des ersten und des zweiten Schalters und Öffnen des dritten wird an das Messinstrument ein fester Bruchteil der Klemmenspannung der Batterie angelegt. Dieser sollte ebenfalls innerhalb eines Sollbereiches liegen, um Störungen an der Batterie oder an erstem oder zweitem Schalter auszuschließen.

Weitere Merkmale und Vorteile der Erfindung ergeben sich aus der nachfolgenden Beschreibung eines Ausführungsbeispiels unter Bezugnahme auf die beigefügte Figur.

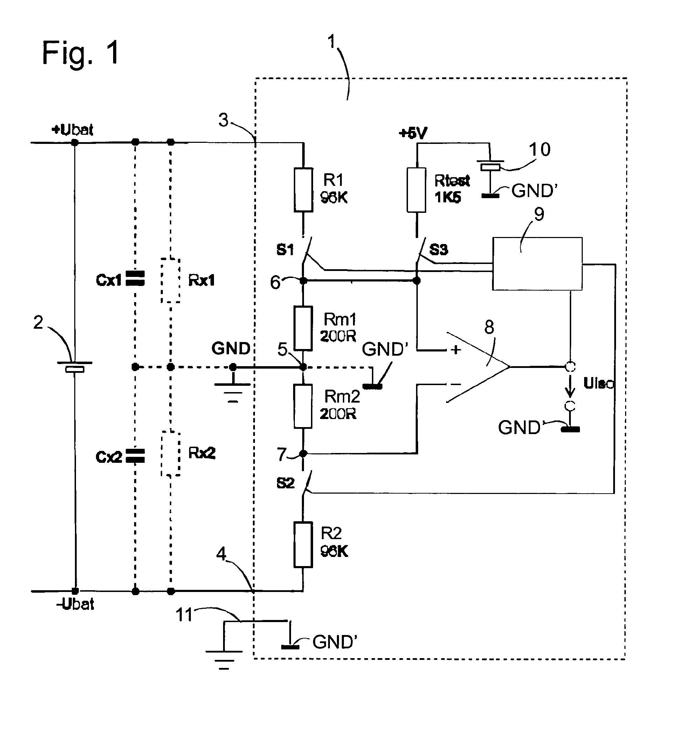

- Fig. 1: zeigt ein schematisches Schaltbild einer erfindungsgemäßen Überwachungsvorrichtung 1 und ihrer Umgebung.

Die Überwachungsvorrichtung 1 ist zum Beispiel in ein elektrisch angetriebenes Fahrzeug eingebaut und überwacht den Isolationswiderstand einer Traktionsbatterie 2 des Fahrzeuges, zum Beispiel eines Brennstoffzellenstapels. Ein nichtverschwindender Isolationswiderstand kann zwischen der positiven Klemme der Batterie 2 mit dem Potential +Ubat und der Masse GND des Fahrzeuges oder zwischen der negativen Klemme mit dem Potential -Ubat und der Fahrzeugmasse GND oder zwischen beiden auftreten und jeweils reale Komponenten, in der Figur dargestellt als Widerstände Rx1, Rx2, als auch imaginäre Komponenten, dargestellt als Kapazitäten Cx1, Cx2 haben.

Zwei Eingänge 3, 4 der Überwachungsvorrichtung 1 sind mit den zwei Klemmen der Batterie 2 verbunden. In der Überwachungsvorrichtung 1 sind die Eingänge 3, 4 durch eine Reihenschaltung eines ersten Vorwiderstandes R1, eines Unterbrechers S1, eines ersten Messwiderstandes Rm1, eines zweiten Messwiderstandes Rm2, eines zweiten Unterbrechers S2 und eines zweiten Vorwiderstandes R2 verbunden. An den Mittelpunkt 5 der Reihenschaltung zwischen den beiden Messwiderständen Rm1, Rm2 ist die Fahrzeugmasse GND angeschlossen. Die zwei Messwiderstände Rm1, Rm2 können als ein Spannungsteiler mit Außenanschlüssen 6, 7 aufgefasst werden. Die Außenanschlüsse 6, 7 sind mit Eingängen eines Differenzverstärkers 8 verbunden. Der Ausgang des Differenzverstärkers 8 liefert eine Ausgangsspannung Uiso, die, wenn beide Schalter S1, S2 geschlossen sind, proportional zur Klemmenspannung der Batterie 2 ist und, wenn einer der Schalter S1, S2 geschlossen und der andere offen ist, für einen eventuellen Isolationsfehler zwischen der mit dem offenen Schalter verbundenen Klemme der Batterie 2 und der Fahrzeugmasse GND repräsentativ ist.

Die Messwiderstände Rm1, Rm2 und die Vorwiderstände sind jeweils untereinander identisch, d. h. sie haben im Rahmen der Toleranz, für die sie spezifiziert sind bzw. so weit für die gewünschte Messgenauigkeit der Schaltung erforderlich, gleiche Widerstandswerte.

Der Außenanschluss 6 ist über einen dritten Schalter S3 und einen Vorwiderstand Rtest mit einem von einer Referenzspannungsquelle 10 bereitgestellten Potential verbunden, bei dem es sich um ein Versorgungspotential des Differenzverstärkers 8 handeln kann und das einen Pegel von +5V in Bezug auf eine lokale Masse GND' der Überwachungsvorrichtung 1 hat. Diese lokale Masse GND' der Leiterplatte, auf der die Komponenten der Überwachungsvorrichtung 1 aufgebaut sind, ist zwar über einen Leitungsdraht 11 an die Fahrzeugmasse GND angeschlossen, es kann aber a priori nicht ausgeschlossen werden, dass ein Stromfluss oder Induktion durch ein externes elektromagnetisches Feld auf einem solchen Leitungsdraht zu einer Spannungsdifferenz zwischen der Fahrzeugmasse GND und der lokalen Masse GND' der Leiterplatte führen.

Die Schalter S1, S2, S3 unterstehen der Kontrolle einer elektronischen Steuereinheit 9, zum Beispiel eines Mikrocontrollers, der auch das Ausgangssignal Uiso des Differenzverstärkers 8 empfängt und auswertet.

Zu Beginn einer von der Steuereinheit 9 durchgeführten Prüfsequenz sind alle Schalter S1, S2, S3 geöffnet. Infolgedessen sind die Eingänge des Differenzverstärkers 8 über die Messwiderstände Rm1, Rm2 auf die Masse GND gezogen, und das Ausgangssignal Uiso des Differenzverstärkers 8 sollte idealerweise Null sein. Wenn in diesem Stadium Uiso Werte unter 0 V oder über 0,1 V annimmt, wird eine Störung eines der Schalter S1, S2, S3 oder des Differenzverstärkers 8 vermutet, und die Steuereinheit 9 gibt eine Fehlermeldung eines ersten Typs aus, die eine Störung der Schaltung 1 anzeigt.

In einem nächsten Schritt schließt die Steuereinheit 9 den Schalter S3, die Schalter S1, S2 bleiben offen. In diesem Zustand liegt am invertierenden Eingang des Differenzverstärkers 8 die Fahrzeugmasse GND und am nichtinvertierenden Eingang ein durch das Verhältnis der Widerstände Rtest und Rm festgelegter Bruchteil der Ausgangsspannung der Quelle 10, gegebenenfalls verschoben um eine Potentialdifferenz zwischen lokaler Masse und Fahrzeugmasse, an. Die Steuereinheit 9 vergleicht Uiso mit einer erwarteten Spannung U = G x Uq x (Rm/(Rm+Rtest)), wobei G die Verstärkung des Differenzverstärkers 8 ist. Je größer die Abweichung zuwischen erwarteter und gemessener Spannung ist, um so stärker ist die Potentialdifferenz zwischen Fahrzeugmasse und lokaler Masse. Bei einer Potentialdifferenz von mehr als 1 V (was bei Rm1 = 200 Ω, Rtest = 1 kΩ und 6 = 4,7 einer gemessenen Spannung | Uiso | > 0,8 V entspricht), wird ein Fehler der Überwachungsschaltung 1 angenommen, und die Steuereinheit 9 erzeugt eine Fehlermeldung des ersten Typs.

In einem letzten Prüfschritt schließt die Steuereinheit die Schalter S1, S2 und öffnet S3. In diesem Zustand liegt ein durch das Verhältnis (Rm1+Rm2)/(R1+R2+Rm1+Rm2) festgelegter Bruchteil der Ausgangsspannung der Batterie 2 an den Eingängen des Differenzverstärkers 8 an. Das Ausmaß der Abweichung zwischen U und Uiso, das von der Steuereinheit 9 akzeptiert wird, ohne dass diese einen Fehler feststellt, muss um so kleiner festgelegt werden, je geringer die eventuellen Leckströme sein sollen, die zu erfassen die Vorrichtung in der Lage sein soll. Typischerweise werden Abweichungen von ± 10% des zu erwartenden Wertes noch als korrekt akzeptiert. Wird diese Abweichung überschritten, so erzeugt wiederum die Steuereinheit 9 eine Fehlermeldung des ersten Typs.

Erst wenn die oben beschriebenen Prüfschritte durchgeführt wurden, ohne dass ein Fehler festgestellt wurde, wird tatsächlich eine Messung des Isolationswiderstandes vorgenommen. Um den Isolationswiderstand zwischen +Ubat und der Fahrzeugmasse zu messen, schließt die Steuereinheit 9 den Schalter S2, während die Schalter S1, S3 offen sind. Strom kann nun über einen eventuellen Isolationswiderstand Rx1, Cx1 zur Fahrzeugmasse GND und von dort über den zweiten Messwiderstand Rm2, den zweiten Schalter S2 und den zweiten Vorwiderstand R2 zur negativen Klemme fließen. Der daraus resultierende Spannungsabfall am zweiten Messwiderstand Rm2 liegt (bei als unendlich angenommenem Eingangswiderstand des Differenzverstärkers 8) vollständig an dessen Eingängen an und wird zum Messsignal Uiso verstärkt.

Für eine Messung des Isolationswiderstandes zwischen Fahrzeugmasse GND und der negativen Anschlussklemme -Ubat der Batterie 1 genügt es, den Schalter S1 zu schließen und den Schalter S2 zu öffnen. Ein eventueller Leckstrom führt dann zu einem positiven Spannungsabfall am ersten Messwiderstand Rm1, der wiederum vom Differenzverstärker 8 verstärkt wird. Die Steuereinheit 9 vergleicht die erhaltenen Messwerte mit einem vorgegebenen Grenzwert und stellt einen Isolationsfehler fest, d.h. sie gibt eine Fehlermeldung eines zweiten Typs aus, wenn wenigstens einer dieser Messwerte den Grenzwert überschreitet.

Um eine Verfälschung der Messung durch parasitäre Kapazitäten Cx1, Cx2 zwischen den Klemmen der Batterie 2 und Masse zu vermeiden, wird bei jeder Messung eine Einschwingzeit von ca. 5 Sekunden zwischen dem Einstellen der Schalter S1, S2 und dem Lesen der aus der jeweiligen Schalterstellung resultierenden Messspannung Uiso durch die Steuereinheit 9 eingehalten.

## Patentansprüche

1. Schaltung (1) zur Überwachung des Widerstandes zwischen den Klemmen einer Batterie (2) und einem ersten Referenzpotential (GND), mit zwei jeweils mit einer der Klemmen der Batterie (2) zu verbindenden Eingängen (3, 4) und einem Spannungsteiler (Rm1, Rm2), der zwei jeweils mit einem der Eingänge (3, 4) verbundene Außenanschlüsse (6, 7) und einen mit dem ersten Referenzpotential (GND) zu verbindenden Mittelanschluss (5) aufweist, mit zwei jeweils in einer Verbindung zwischen einem der Außenschlüsse (6, 7) des Spannungsteilers (Rm1, Rm2) und einem der Eingänge (3, 4) in Reihe angeordneten ersten und zweiten Schaltern (S1, S2) und mit einem mit den Außenanschlüssen (6, 7) des Spannungsteilers verbundenen Messinstrument (8) zum Liefern eines für die Spannung zwischen den Außenanschlüssen (6, 7) repräsentativen Überwachungssignals (Uiso) .

2. Schaltung nach einem der vorhergehenden Ansprüche,
**dadurch gekennzeichnet, dass** jeweils zwischen dem Mittelanschluss (5) und den beiden Außenanschlüssen (6, 7) des Spannungsteilers in Reihe geschaltete Widerstände (Rm1, Rm2) identisch sind.

3. Schaltung nach einem der vorhergehenden Ansprüche,
**dadurch gekennzeichnet, dass** in jeder Verbindung zwischen einem der Außenanschlüsse (6, 7) des Spannungsteilers und einem der Eingänge (3, 4) ein Vorwiderstand (R1, R2) in Reihe geschaltet ist.

4. Schaltung nach Anspruch 3,
**dadurch gekennzeichnet, dass** die Vorwiderstände (R1, R2) identisch sind.

5. Schaltung nach einem der vorhergehenden Ansprüche,
**dadurch gekennzeichnet, dass** sie eine Steuereinheit (9) zum gegenphasigen Öffnen und Schließen des ersten und des zweiten Schalters aufweist.

6. Schaltung nach einem der Ansprüche 2 bis 5,
**dadurch gekennzeichnet, dass** die Widerstände (R1, R2, Rm1, Rm2) ohmsche Widerstände sind.

7. Schaltung nach einem der vorhergehenden Ansprüche,
**dadurch gekennzeichnet, dass** das Messinstrument (8) ein Differenzverstärker ist.

8. Schaltung nach Anspruch 7,
**dadurch gekennzeichnet, dass** der Differenzverstärker (8) mit einem zweiten Referenzpotential (GND') als ein Versorgungspotential beschaltet ist, und dass von zwei Klemmen einer Prüfspannungsquelle (10) die eine mit einem das zweite Referenzpotential (GND') führenden Punkt der Schaltung verbunden ist und die andere über einen dritten Schalter (S3) mit einem der Außenanschlüsse (6) des Spannungsteilers verbunden ist.

9. Schaltung nach Anspruch 8, **dadurch gekennzeichnet, dass** die Schalter (S1, S2, S3), die Widerstände (R1, R2, Rm1, Rm2) und das Messinstrument (8) in einer Baueinheit zusammengefasst sind, dass der Mittelanschluss (5) des Spannungsteilers (Rm1, Rm2) durch einen ersten Leiter an das außerhalb der Baueinheit definierte erste Referenzpotential (GND) angeschlossen ist, und dass das zweite Referenzpotential (GND') definiert ist durch einen zweiten Leiter (11), der den Punkt mit dem ersten Referenzpotential (GND) verbindet.

10. Fahrzeug mit einer Batterie (2) und einer Schaltung (1) nach einem der vorhergehenden Ansprüche, bei dem das erste Referenzpotential die Fahrzeugmasse (GND) ist.

11. Verfahren zum Betreiben einer Schaltung nach einem der Ansprüche 1 bis 9, **dadurch gekennzeichnet, dass** der erste Schalter (S1) geschlossen und der zweite Schalter (S2) geöffnet und eine erste an dem Messinstrument (8) anliegende Spannung erfasst wird, dass der erste Schalter (S1) geöffnet und der zweite Schalter (S2) geschlossen und eine zweite an dem Messinstrument anliegende Spannung erfasst wird, und dass ein Isolationsfehler angezeigt wird, wenn eine der erfassten Spannungen einen Grenzwert überschreitet.

12. Verfahren nach Anspruch 11, **gekennzeichnet durch** einen Schritt des Öffnens aller Schalter (S1, S2, S3), des Erfassens der an dem Messinstrument (8) anliegenden Spannung, und des Erkennens eines Fehlers der Schaltung (1), wenn die Spannung außerhalb eines Sollbereichs liegt.

13. Verfahren nach Anspruch 11 oder Anspruch 12, **gekennzeichnet durch** einen Schritt des Öffnens des ersten und des zweiten Schalters (S1, S2) und des Schließens des dritten Schalters (S3), des Erfassens der an dem Messinstrument (8) anliegenden Spannung, und des Erkennens eines Fehlers der Schaltung (1), wenn die Spannung außerhalb eines Sollbereichs liegt.

14. Verfahren nach einem der Ansprüche 11 bis 13, **gekennzeichnet durch** einen Schritt des Schließens des ersten und des zweiten Schalters (S1, S2) und des Öffnens des dritten Schalters (S3), des Erfassens der an dem Messinstrument (8) anliegenden Spannung, und des Erkennens eines Fehlers der Schaltung (1), wenn die Spannung außerhalb eines Sollbereichs liegt.
